# EUROPÄISCHE PATENTSCHRIFT

(11) **EP 3 411 513 B1**
(45) Veröffentlichungstag und Bekanntmachung des Hinweises auf die Patenterteilung: **02.06.2021**
(21) Anmeldenummer: 17703720.7
(22) Anmeldetag: 03.02.2017
(51) Int. Cl.: C23C 14/06, C23C 14/02, C23C 14/56, H01L 31/0296, H01L 31/20, C23C 14/00, C23C 16/30, H01L 27/146, H01L 31/18

(54) **VERFAHREN ZUM ABSCHEIDEN EINER CDTE-SCHICHT AUF EINEM SUBSTRAT**
METHOD FOR DEPOSITING A CDTE LAYER ON A SUBSTRATE
PROCÉDÉ DE DÉPÔT D'UNE COUCHE CDTE SUR UN SUBSTRAT

(30) Priorität: 03.02.2016 DE 102016101856
(43) Veröffentlichungstag der Anmeldung: 12.12.2018
(73) Patentinhaber: Fraunhofer-Gesellschaft zur Förderung der angewandten Forschung e.V., 80686 München (DE); CTF Solar GmbH, 01109 Dresden (DE)
(72) Erfinder: MORGNER, Henry, 01257 Dresden (DE); METZNER, Christoph, 01328 Dresden (DE); HIRSCH, Daniel, 01309 Dresden (DE); ZYWITZKI, Olaf, 01309 Dresden (DE); DECKER, Ludwig, 01328 Dresden (DE); WERNER, Torsten, 01219 Dresden (DE); SIEPCHEN, Bastian, 01109 Dresden (DE); SPÄTH, Bettina, 01109 Dresden (DE); VELAPPAN, Krishnakumar, 01109 Dresden (DE); KRAFT, Christian, 01109 Dresden (DE); DROST, Christian, 01109 Dresden (DE)
(86) Internationale Anmeldenummer: PCT/EP2017/052323
(87) Internationale Veröffentlichungsnummer: WO 2017/134191

(56) Entgegenhaltungen:
- EP-A2- 0 535 522
- JP-A- 2007 317 834
- US-A- 4 207 119
- US-A1- 2006 032 440
- KEEDONG YANG ET AL: "Vapor transport deposition of large-area polycrystalline CdTe for radiation image sensor application", PHYSICA STATUS SOLIDI. C: CURRENT TOPICS IN SOLID STATE PHYSICS, Bd. 11, Nr. 7-8, 25. März 2014 (2014-03-25), Seiten 1341-1344, XP055365913, DE ISSN: 1862-6351, DOI: 10.1002/pssc.201300600 in der Anmeldung erwähnt

## Beschreibung

### Beschreibung

Die Erfindung betrifft ein Verfahren zum Abscheiden einer CdTe-Schicht auf einem Substrat, mit welchem mindestens ein zusätzliches chemisches Element in die abgeschiedene Schicht eingelagert werden kann.

CdTe-Schichten erlangen eine zunehmende Bedeutung in der Halbleiterindustrie, vornehmlich beim Herstellen von Dünnschichtsolarzellen oder Bildaufnehmern für Kameras.

In JP 2007 317834 A werden Lösungen aufgezeigt, wie auf flexiblen Substraten Schichtsysteme CIS-basierter Dünnschichtsolarzellen ausgebildet werden können.

Für das Abscheiden von CdTe-Schichten ist die Prozesstechnologie der so genannten "Close Space Sublimation" mit dem Kürzel CSS weit verbreitet. Hierbei wird CdTe-Granulat in einem Gefäß erhitzt, welches im Gefäß sublimiert und so in einen dampfförmigen Zustand überführt wird. Ein zu beschichtendes und auf Beschichtungstemperatur erwärmtes Substrat wird meist dicht über das Gefäß hinwegbewegt, infolgedessen sich CdTe auf der Substratoberfläche niederschlägt.

Das Abscheiden von CdTe-Schichten mittels CSS für Dünnschichtsolarzellen ist beispielsweise in "CdTe Dünnschichtsolarmodule auf dem Weg zur Produktion", Dr. Dieter Bonnet, FVS Themen 2000, Seite 116-118, beschrieben.

Aus DE 10 2014 202 961 A1 ist ein Verfahren zum Herstellen einer p-dotierten CdTe-Schicht bekannt, bei welchem zwei CdTe-Teilschichten beispielsweise mittels CSS abgeschieden werden und zwischen die zwei Teilschichten eine Opferschicht, welche das Dotierelement umfasst. Von der Opferschicht aus diffundiert das Dotierelement in angrenzende Bereiche der CdTe-Teilschichten.

Alternativ ist es auch möglich, beim CSS-Prozess einen reaktiven Abscheidevorgang durchzuführen, indem ein Reaktivgas wie beispielsweise Sauerstoff in den Bereich des sich ausbreitenden CdTe-Dampfes zwischen sublimierendem CdTe-Granulat und zu beschichtendem Substrat eingelassen wird. Nachteilig wirkt sich hierbei aus, dass dabei auch das CdTe-Granulat im Gefäß oxidiert, was die Dampfausbeute negativ beeinflusst.

Aus US 4 207 119 A ist die Herstellung einer Dünnschicht-Photovoltaikzelle bekannt, in der zusammenhängende Schichten aus polykristallinem CdS vom n-Typ und polykristallinem CdTe vom p-Typ durch Close-Space-Sublimation getrennt abgeschieden werden. Mindestens eine der Schichten wird in Gegenwart von O2-Gas abgeschieden.

Ein weiter bekannter Prozess zum Abscheiden von CdTe-Schichten ist die sogenannte "Vapor Transport Deposition" mit dem Kürzel VTD. Beim VTD-Abscheideverfahren wird CdTe in einem Gefäß in den dampfförmigen Zustand überführt und der CdTe-Dampf mittels des Gasstromes eines inerten Trägergases in eine Beschichtungszone geführt, in welcher der CdTe-Dampf auf einem Substrat abgeschieden wird. Das VTD-Abscheideverfahren wird meist zum Beschichten der Oberseite eines Substrates mit der Beschichtungsrichtung von oben nach unten verwendet. Aus DE 10 2010 051 815 A1 ist beispielsweise ein Prozess zum Bilden mindestens einer photovoltaischen Komponente bekannt, bei dem eine Absorberschicht, die beispielsweise aus CdTe hergestellt wird, mittels VTD abgeschieden werden kann.

US 2006/032440 A1 gibt eine Lösung an, wie ein plattenförmiges Substrat mittels VTD von der Substratunterseite her beschichtet werden kann. Hierzu wird das Substrat beispielsweise über eine Heizplatte geführt, welche eine Vielzahl von Öffnungen aufweist, durch welche ein erhitztes Gas gegen das Substrat gepresst wird, so dass das Substrat über der Heizplatte in Schwebe gehalten und berührungslos über eine Beschichtungsstation hinweg bewegt werden kann.

"Vapor transport deposition of large-area polycrystalline CdTe for radiation image sensor application", Keedong Yang, Bokyung Cha, Duchang Heo, and Sungchae Jeon, Phys. Status Solidi, C 11, Nr. 7-8, 2014, Seite 1341-1344, beschreibt das Abscheiden von CdTe-Schichten mittels VTD für Bildaufnehmer-Anwendungen.

Bei Abscheiden einer CdTe-Schicht mittels VTD ist es möglich, in die CdTe-Schicht weitere chemische Elemente einzulagern, indem beispielsweise dem Trägergas eine gasförmige Komponente des beizugebenden chemischen Elements beigefügt wird. Wenn zum Beispiel Sauerstoff dem inerten Trägergas beigemischt wird, wirkt sich das jedoch negativ dahingehend aus, dass der Sauerstoff während des Transports des CdTe-Dampfes zur Beschichtungszone mit Partikeln des CdTe-Dampfes zu Cadmiumoxid reagiert, was die Qualität der abgeschiedenen Schicht mindert.

Der Erfindung liegt daher das technische Problem zugrunde, ein Verfahren zum Abscheiden einer CdTe-Schicht auf einem Substrat zu schaffen, mittels dessen die Nachteile aus dem Stand der Technik überwunden werden können. Insbesondere soll es mit dem erfindungsgemäßen Verfahren auch möglich sein, zusätzliche chemische Elemente in die abgeschiedene Schicht einzulagern, ohne eine chemische Veränderung des Verdampfungsgutes, wie beispielsweise durch Oxidieren, zu bewirken.

Die Lösung des technischen Problems ergibt sich durch Gegenstände mit den Merkmalen des Patentanspruchs 1. Weitere vorteilhafte Ausgestaltungen der Erfindung ergeben sich aus den abhängigen Ansprüchen.

Beim erfindungsgemäßen Verfahren wird innerhalb einer Vakuumkammer eine CdTe-Schicht mittels eines CSS-Prozesses auf einem Substrat abgeschieden. Als Substrate können beispielsweise Glassubstrate verwendet werden, auf denen vor dem Abscheiden der CdTe-Schicht auch schon eine oder mehrere Schichten aus anderen Materialien als CdTe abgeschieden sein können. Alternativ können aber auch Substrate aus Metall oder aus Kunststoff verwendet werden. Beim erfindungsgemäßen Verfahren wird ein mit CdTe zu beschichtendes Substrat vor dem Abscheideprozess auf eine Beschichtungstemperatur erwärmt und anschließend an mehreren Gefäßen vorbeigeführt, in welchem CdTe in einen dampfförmigen Zustand überführt wird, so dass der entstehende CdTe-Dampf auf der zu beschichtenden Oberfläche des Substrates abgeschieden wird. Das erfindungsgemäße Verfahren zeichnet sich dadurch aus, dass in die abgeschiedene CdTe-Schicht mindestens ein weiteres chemisches Element eingelagert wird, mit welchem beispielsweise die elektrische Leitfähigkeit der CdTe-Schicht beeinflusst werden kann. Realisiert wird dies erfindungsgemäß, indem vor jedem Gefäß durch mindestens einen Einlass eine sauerstoffhaltige gasförmige Komponente mit einem erhöhtem Druck (gegenüber dem Vakuum in der Vakuumkammer) gegen die zu beschichtenden Oberfläche des Substrates strömt, so dass die sauerstoffhaltige gasförmige Komponente an der zu beschichtenden Oberfläche des Substrates adsorbiert, bevor das Substrat an dem jeweils nachfolgenden Gefäß, in welchem CdTe in einen dampfförmigen Zustand überführt wird, vorbeigeführt wird. Die an der Substratoberfläche anhaftende gasförmige Komponente wird dann beim nachfolgenden Aufdampfen des CdTe mit in die entstehende Schicht eingebunden.

Sauerstoff als gasförmige Komponente ist besonders geeignet, wenn die CdTe-Schicht als Bestandteil eines Solarzellen-Schichtsystems abgeschieden wird, weil durch den eingelagerten Sauerstoff das erwünschte Hineindiffundieren von Chlor und Schwefel in die CdTe-Schicht aus angrenzenden Schichten verstärkt wird, was einen erhöhten Wirkungsgrad bei der Solarzelle bewirkt.

Bei einer weiteren Ausführungsform wird die gasförmige Komponente vor und/oder nach dem Adsorbieren an der Substratoberfläche mittels eins Plasmas aktiviert, was das Einbinden von chemischen Elementen der gasförmigen Komponente in die CdTe-Schicht verbessern kann.

Außerdem kann beim erfindungsgemäßen Verfahren der CdTe-Dampf mittels eines Plasmas aktiviert werden, wodurch die Eigenschaften der abgeschiedenen CdTe-Schicht beeinflusst werden können.

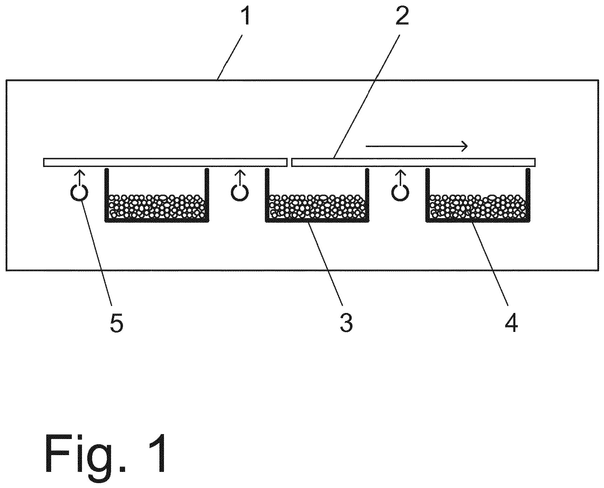

Die vorliegende Erfindung wird nachfolgend anhand eines Ausführungsbeispiels näher erläutert. Die Fig. 1 zeigt eine schematische Darstellung einer Vorrichtung, mittels der das erfindungsgemäße Verfahren durchführbar ist. Durch eine Vakuumkammer 1 werden Substrate 2 geführt, auf welchen auf einer Seite eine CdTe-Schicht als Teil eines Solarzellenschichtsystems abgeschieden werden soll. Dabei soll auch noch das chemische Element Sauerstoff möglichst gleichmäßig in die abgeschiedene CdTe-Schicht eingelagert werden.

Im Ausführungsbeispiel bestehen die Substrate aus Glas, auf dem bereits in vorhergehenden Prozessen eine TCO-Schicht und nachfolgend eine CdS-Schicht abgeschieden wurden. Bevor die Substrate 2 in die Vakuumkammer 1 geführt werden, wurden diese auf eine Beschichtungstemperatur erwärmt. Das Erwärmen der Substrate 2 auf eine Beschichtungstemperatur bzw. das Aufrechterhalten einer Beschichtungstemperatur der Substrate 2 kann alternativ auch innerhalb der Vakuumkammer 1 beispielsweise mittels Strahlungsheizern erfolgen.

Innerhalb der Vakuumkammer 1 sind drei Gefäße 3 in Substratbewegungsrichtung, welche durch einen Pfeil oberhalb der Substrate 2 veranschaulicht wird, angeordnet. Innerhalb der Gefäße 3 befindet sich CdTe-Granulat 4, welches aufgrund einer Wärmezufuhr in den Gefäßen 3 sublimiert. Die Substrate 2 werden mit einem Abstand von nur wenigen Millimetern über die Gefäße 3 geführt, infolgedessen eine CdTe-Schicht auf den Substraten 2 abgeschieden wird.

Erfindungsgemäß ist in Substratbewegungsrichtung betrachtet vor jedem Gefäß 3 ein Gaseinlass 5 angeordnet, aus welchem Sauerstoff in Richtung der zu beschichteten Substratoberfläche strömt. Die Strömungsrichtung des Sauerstoffs ist im Ausführungsbeispiel senkrecht zur zu beschichtenden Substratoberfläche. Der Sauerstoff adsorbiert an der zu beschichtenden Substratoberfläche, wird anhaftend an dem Substrat 2 mit diesem in die Beschichtungszone eines jeweils nachfolgenden Gefäßes 3 geführt und dort bei der Schichtabscheidung in die abgeschiedene Schicht eingebunden.

Wird ein Substrat 2, wie im Ausführungsbeispiel beschrieben, mehrfach durch die Beschichtungszone eines oder mehrerer Gefäße 3 geführt und zuvor jedes Mal eine gasförmige Komponente an der zu beschichtenden Substratoberfläche adsorbiert, so stellt das erfindungsgemäße Verfahren eine Möglichkeit dar, mindestens ein zusätzliches chemisches Element gleichmäßig über den Schichtdickenverlauf einer CdTe-Schicht einzulagern.

Weil die Substrate 2 mit einem Abstand von nur wenigen Millimetern über die Gefäße 3 geführt werden, sind zum einen die seitlichen Abdampfungsverluste sehr gering und zum anderen gelangt wegen des geringen Spaltes zwischen Substrat 2 und dem Gefäßrand im Zusammenhang mit dem relativ hohen Dampfdruck, der sich innerhalb des Gefäßes 3 im Bereich zwischen CdTe-Granulat 4 und dem Substrat 2 aufbaut, nur sehr wenig Sauerstoff an das CdTe-Granulat. Dadurch ist der Oxidationsgrad des CdTe-Granulats innerhalb der Gefäße 3 vernachlässigbar gering und die Dampfausbeute sehr hoch.

Es ist bekannt, dass bei einem Solarzellen-Schichtsystem nach dem Abscheiden einer CdTe-Schicht eine Aktivierung der CdTe-Schicht mit einer Chlorverbindung dahingehend erfolgt, dass Chlor in die CdTe-Schicht diffundieren soll. Überraschend hat sich gezeigt, dass das erfindungsgemäße Einlagern von Sauerstoff in eine CdTe-Schicht sowohl das Eindiffundieren von Chlor infolge einer nachfolgenden Chlor-Aktivierung als auch das Eindiffundieren von Schwefel aus einer unterhalb der CdTe-Schicht abgeschiedenen CdS-Schicht begünstigt. Bei Solarzellen mit erfindungsgemäß abgeschiedener CdTe-Schicht konnte deshalb ein höherer Wirkungsgrad ermittelt werden gegenüber Verfahren ohne erfindungsgemäß eingelagerten Sauerstoff.

Eine Analyse von erfindungsgemäß abgeschiedenen CdTe-Schichten hat ferner aufgezeigt, dass das erfindungsgemäße Einlagern von Sauerstoff in eine CdTe-Schicht nicht zum Ausbilden von Cadmiumoxid innerhalb der CdTe-Schicht führt.

Angemerkt sei noch einmal, dass mit dem erfindungsgemäßen Verfahren nicht nur Sauerstoff in eine CdTe-Schicht eingebunden werden kann, sondern auch andere, zuvor schon einmal benannte chemische Elemente, um die CdTe-Schicht beispielsweise zu dotieren. Auch sind die in Fig. 1 dargestellten drei Gefäße 3 von der Anzahl her lediglich beispielhaft. In Abhängigkeit von einer Aufgabenstellung kann das erfindungsgemäße Verfahren auch mit mehr oder weniger als drei Gefäßen 3 sowie den zugehörigen Gaseinlässen 5 durchgeführt werden.

## Patentansprüche

1. Verfahren zum Abscheiden einer CdTe-Schicht auf einem Substrat (2) innerhalb einer Vakuumkammer (1) mittels eines Cose Space Sublimation Prozesses, bei welchem das Substrat (2) vor dem Abscheideprozess auf eine Beschichtungstemperatur erwärmt und anschließend an mehreren Gefäßen (3) vorbeigeführt wird, in welchen CdTe (4) in einen dampfförmigen Zustand überführt wird, **dadurch gekennzeichnet, dass** vor jedem Gefäß (3) durch mindestens einen Einlass (5) eine sauerstoffhaltige gasförmige Komponente, mit gegenüber dem Vakuum in der Vakuumkammer erhöhtem Druck gegen die zu beschichtende Oberfläche des Substrates (2) strömt, so dass die sauerstoffhaltige gasförmige Komponente an der zu beschichtenden Oberfläche des Substrates (2) adsorbiert, bevor das Substrat (2) an dem jeweils nachfolgenden Gefäß (3) vorbeigeführt wird.

2. Verfahren nach Anspruch 1, **dadurch gekennzeichnet, dass** die gasförmige Komponente mittels eines Plasmas aktiviert wird.

3. Verfahren nach einem der vorhergehenden Ansprüche, **dadurch gekennzeichnet, dass** der CdTe-Dampf mittels eines Plasmas aktiviert wird.

## Claims

1. Method of depositing a CdTe layer on a substrate (2) within a vacuum chamber (1) by means of a close space sublimation process, in which the substrate (2), prior to the deposition process, is heated to a coating temperature and then guided past multiple vessels (3) in which CdTe (4) is converted to a vaporous state, **characterized in that**, upstream of each vessel (3), through at least one inlet (5) an oxygen-containing gaseous component having elevated pressure relative to the vacuum in the vacuum chamber flows toward the surface of the substrate (2) to be coated, in such a way that the oxygen-containing gaseous component is adsorbed at the surface of the substrate (2) to be coated before the substrate (2) is guided past the respective next vessel (3).

2. Method according to Claim 1, **characterized in that** the gaseous component is activated by means of a plasma.

3. Method according to any of the preceding claims, **characterized in that** the CdTe vapour is activated by means of a plasma.

## Revendications

1. Procédé pour le dépôt d'une couche de CdTe sur un substrat (2) à l'intérieur d'une enceinte à vide (1) au moyen d'un processus de sublimation en espace fermé, dans lequel le substrat (2) est chauffé à une température de revêtement avant le processus de dépôt et ensuite est passé devant plusieurs récipients (3) dans lesquels du CdTe (4) est converti à l'état de vapeur, **caractérisé en ce que** devant chaque récipient (3), à travers au moins une entrée (5), un composant gazeux contenant de l'oxygène, doté d'une pression élevée par rapport au vide dans l'enceinte à vide, s'écoule vers la surface devant être revêtue du substrat (2), de sorte que le composant gazeux contenant de l'oxygène soit adsorbé au niveau de la surface devant être revêtue du substrat (2), avant que le substrat (2) ne soit passé devant le récipient respectif suivant (3).

2. Procédé selon la revendication 1, **caractérisé en ce que** le composant gazeux est activé au moyen d'un plasma.

3. Procédé selon l'une quelconque des revendications précédentes, **caractérisé en ce que** les vapeurs de CdTe sont activées au moyen d'un plasma.
